Europäisches Patentamt

European Patent Office

Office européen des brevets

(11) Publication number: **0 252 771 B1**

# EUROPEAN PATENT SPECIFICATION

(45) Date of publication of patent specification: **02.12.92**   (51) Int. Cl.⁵: **B23K 3/06**, H01L 21/00

(21) Application number: **87306187.3**

(22) Date of filing: **13.07.87**

(54) **Soldering apparatus.**

(30) Priority: **11.07.86 GB 8616939**

(43) Date of publication of application:
**13.01.88 Bulletin 88/02**

(45) Publication of the grant of the patent:
**02.12.92 Bulletin 92/49**

(84) Designated Contracting States:
**AT BE CH DE ES FR GB GR IT LI LU NL SE**

(56) References cited:
**DE-A- 2 121 993
GB-A- 2 036 625
US-A- 4 285 457
US-A- 4 311 265**

**PATENT ABSTRACTS OF JAPAN, vol. 10, no. 153 (M-484)[2209], 3rd June 1986; & JP-A-61 7063 (ALPS DENKI K.K.) 13-01-1986**

(73) Proprietor: **SUN INDUSTRIAL COATINGS PRI-VATE LTD.
No. 8 Third Lok Yang Road
Jurong Singapore 2262(SG)**

(72) Inventor: **Sim, Ah Tee
Marine Drive Unit 14-104
Block 62 Singapore 1544(SG)**

(74) Representative: **Piesold, Alexander J. et al
Frank B. Dehn & Co. Imperial House 15-19
Kingsway
London WC2B 6UZ(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

EP 0 252 771 B1

## Description

This invention relates to soldering apparatus and is particularly concerned with systems in which components to be coated with solder are passed through a bath of solder. The invention is particularly concerned with applying solder to the leads of integrated circuit packs, such as dual-in-line (DIP), SOIC or other types, mounted in tracks of a horizontally oriented carrier.

Frequently, such coating is carried out in a wave soldering system, as referred to in EP-A-0 171 257. In such a system (on which the precharacterising part of claim 1 is based) a carrier for the components may be passed over a bath of solder in which a standing wave is formed. The arrangement is such that the component portions to be coated pass through the peak of the standing wave of solder as the carrier is moved over the bath.

A problem with certain known systems is that it is difficult to control the quality of the coating, particularly as regards an even thickness. Frequently, package leads have regions where the coating is significantly thicker than elsewhere. Another problem is that of accommodating various different types of components which may be handled, particularly as regards the depth of immersion in the wave of solder. For example, a DIP may require immersion to a depth of 6mm whereas an SOIC - designed for surface mounting on a circuit board - may require a depth of e.g. only 1.2mm. To cope with such a range of depths it may be necessary to change the wave height or even to use separate apparatus dedicated to the individual components.

There has been proposed a system for dipping individual carriers vertically into and removing them vertically out of a bath of solder. This provides an improvement in quality over wave soldering apparatus but has the disadvantage of being considerably slower since carriers cannot be processed continuously.

There is thus a need for a system which will achieve some of the benefits of both wave soldering and dip soldering integrated circuit packs so as to provide both reasonable quality and reasonable speed of operation, and preferably greater versatility.

It is known from US-A-4 285 457 and US-A- 4 311 265 to provide systems for soldering electrical components to printed circuit boards, in which a carrier for a board has front and rear wheels and is conveyed along tracks having depressions arranged to lower the carrier and dip the board into a solder bath whilst keeping the board horizontal. The depressions for the front and rear wheels are aligned in the conveying direction, and in order to prevent the front wheel from following the depression provided for the rear wheel and the rear wheel from following the depression provided for the front wheel, each of these known systems has an auxiliary track.

It is known from GB-A-2 036 625 to provide a system for soldering electrical components to printed circuit boards, in which a track has first and second profiled regions laterally offset from each other, and a carrier for a printed circuit board has first and second followers for supporting the leading and trailing portions of the carrier which are likewise laterally offset from each other, so that when the carrier is urged along the track the first follower bypasses the second profiled region and the second follower bypasses the first profiled region. The longitudinal spacing between the descending parts of the first and second profiled regions is less than the longitudinal spacing between the first and second followers, to ensure that the carrier is tilted as the printed circuit board is dipped into a solder bath.

Viewed from one aspect the invention provides in combination, a horizontally oriented carrier having tracks arranged to have removably mounted therein electronic integrated circuit packs with their leads pointing downwards, and apparatus for applying solder to the leads of the packs, the combination including a solder bath, a guide track for guiding the carrier across the solder bath, means for urging the carrier along the guide track, a first follower for supporting a leading portion of the carrier on the guide track, and a second follower longitudinally spaced from the first follower for supporting a trailing portion of the carrier on the guide track, characterised in that the guide track has a first profiled region for guiding the first follower down towards the surface of the solder, and a second profiled region longitudinally spaced from the first region for simultaneously guiding the second follower down towards the surface of the solder the first and second profiled regions of the guide track being laterally offset from each other, and the first and second followers for supporting the leading and trailing portions of the carrier being likewise laterally offset from each other so that when the carrier is urged along the guide track the first follower bypasses the second profiled region and the second follower bypasses the first profiled region, wherein the profiles of the first and second profiled regions are the same and the longitudinal spacing of the profiled regions from each other is the same as the longitudinal spacing of the first and second followers from each other, so that when the carrier is Urged along the guide track it maintains its horizontal orientation at the same time as being moved vertically towards and away from the surface of the solder so as to dip the leads of the packs in the solder.

With such an arrangement, the integrated circuit packs are subjected to vertical dipping but at the same time are moved across the bath. By using a number of carriers on the track, one after the other, continuous operation can be achieved. The vertical dipping gives better quality coating, and the speed and depth of descent can be determined by the profiles in the specific regions of the track.

The significance of having separate, spaced profiled regions for the leading and trailing portions of the carrier, is that it is maintained in a horizontal orientation whilst being dipped and moved across the bath of solder. If there was only one profiled region which the leading and trailing edges followed in series, then the carrier would be inclined as it moved towards and away from the surface of the solder. This would produce uneven and poorer quality coating.

The two profiled regions on a track are offset laterally, with corresponding followers supporting the leading and trailing portions of the carrier being likewise laterally displaced with respect to each other. Thus, the leading follower will bypass one region and continue on a flat portion of track until it reaches its associated profiled region. At this point the trailing follower will reach its associated profiled region. After the dipping operation, the trailing follower will bypass the next profiled region, continuing on a flat portion of track.

Normally, the carrier would be guided by a track on each side, each track having the profiled regions described above, which would of course be aligned.

The profile in each profiled region will generally consist of a downwardly inclined region, a horizontal region, and and upwardly inclined region. The inclination of the inclined regions determines the rate of descent and ascent, and one rate could be greater than the other if desired. The inclined regions could be flat or have a more complex profile so as to provide a variable rate of descent and/or ascent.

The followers may, for example, be in the form of wheels, rollers, non-rotatable but low friction elements, or the like. The followers may be integral with the carrier, or attachable to the carrier, or part of a movable support for the carrier.

The carrier itself may be of any suitable type, for example, of the type shown in the European Patent Application 0171257, although it may be modified if necessary so as to operate in the apparatus described herein.

The means for urging the carriers along the track can be in any suitable form but one preferred embodiment comprises a chain conveyor with a plurality of fingers for engagement with the carrier.

The carrier may be provided with a notch for receiving the finger. The finger should have a sufficient vertical extent to remain in contact with the carrier during the dipping operation. Alternatively, the carrier could have a portion of sufficient vertical extent to remain in contact with a shallower finger or like member.

It is most advantageous if the profiled regions are readily replaceable. In this way it is easy to adapt the apparatus for different components by altering the rate and depth of descent and ascent as well as the total time of immersion. Each profiled region could be provided on a separate replaceable member but preferably the associated pair of regions is provided on a single replaceable member such as a block. This provides considerable advantages over a wave soldering system in which the height of the wave has to be altered.

An embodiment of apparatus exemplifying some of the above-mentioned and other features and broad aspects will now be described by way of example only and with reference to the accompanying diagramatic drawings in which;-

Fig. 1 is a perspective, exploded view of guide tracks for use in the apparatus; and

Fig. 2 is a section through part of the apparatus.

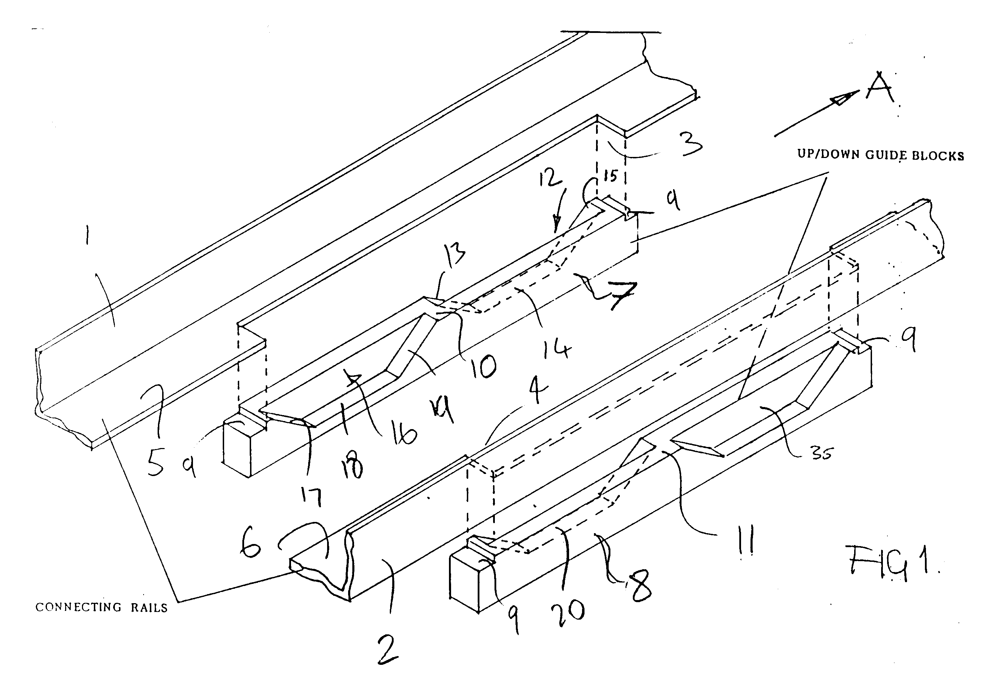

Referring now in detail to the drawings, in Figure 1 there is shown a left hand guide track 1 in the form of an "L"-section angle bar, and a corresponding right hand guide track 2 also in the form of an "L"-section angle bar. On the apparatus, the tracks 1 and 2 will be arranged parallel to guide a carrier in the direction of arrow A. The tracks 1 and 2 have aligned cut-outs 3 and 4 on the lower guide surfaces 5 and 6 adapted to receive profiled blocks 7 and 8 respectively. These blocks are to be located releasably in the cut-outs by sutable means so that they can be changed to provide different profiles. The blocks are recessed as shown at 9 so that when received in the cut-outs 3 and 4 their upper surfaces 10 and 11 respectively will be flush with surfaces 5 and 6 of the tracks 1 and 2.

Referring to block 7, it has a leading profiled region 12 formed in the left hand or outer part of the leading end of the block. This profiled region consists of a downwardly inclined ramp 13 descending from the upper surface 10, a horizontally extending portion 14 and an upwardly inclined ramp 15 leading back up to the upper surface 10. The width of the region is approximately one half of the width of the block 7.

The block 7 also has a trailing profiled region 16 formed in the right hand or upper part of the trailing end of the block, again having a width of approximately one half the width of the block 7. This trailing profiled region 16 is thus laterally offset from the leading profiled region and has a profile identical in shape and dimensions to that of leading profiled region 12, with a downwardly inclined ramp 17, a horizontal portion 18 and an upwardly inclined ramp 19.

The spacing between the start of ramp 17 and the start of ramp 13, and thus the spacing between all other corresponding parts of the profiled regions, is equal to the spacing between leading and trailing followers which will support a carrier and follow the leading and trailing profiles respectively. Thus, assuming that the carrier is horizontal as the followers move along the level surface 5 of track 1, then it will remain horizontal as the followers pass through the profiled regions although it will be lowered and raised in accordance with the profiles.

The right hand block 8 is an exact mirror image of block 7, with profiled regions 19 and 20 being mirror images of regions 12 and 16 respectively with identical profiles. The block 7 and 8 are longitudinally aligned on the tracks 1 and 2. Thus right hand followers, aligned with left hand followers, will follow the profile at the same time and ensure that a supported carrier is kept level at all times.

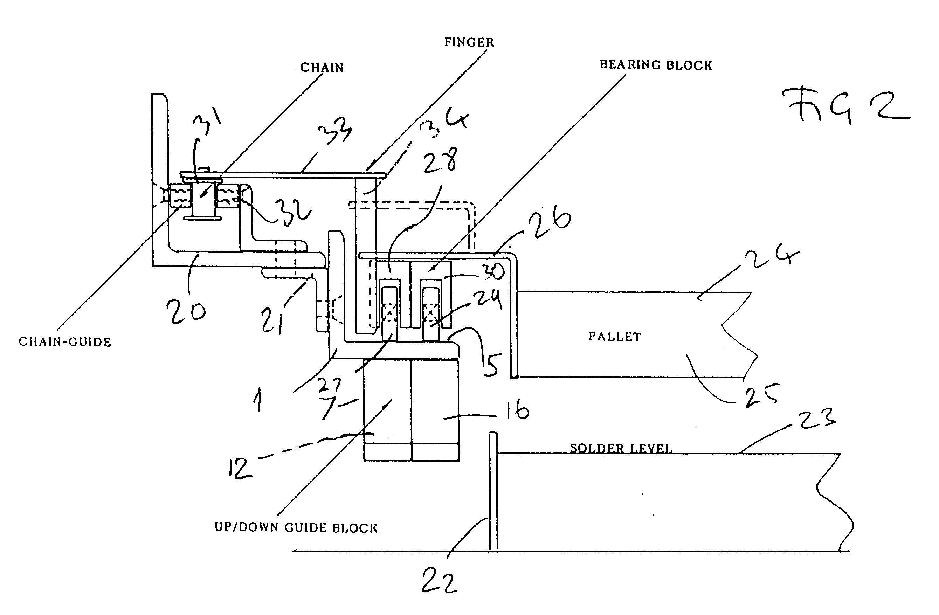

Referring now to Figure 2, the left hand side of soldering apparatus is shown. The left hand track 1 is arranged horizontally, being mounted on a frame 20 by means of an angle piece 21. The track 1 runs along the side of a solder bath 22 containing solder with a level surface 23. Above the bath 22 is provided a carrier 24 for components, for example of the type shown in European Patent Appliction 0171257. The carrier 24 has a central region 25 containing components mounted on tracks with their leads pointing downwardly, and a support 26 on its left hand side. Underneath this support is mounted a leading follower in the form of a rotatable wheel 27 in a bearing block 28, on the outside of the support 26. Also provided is a trailing follower in the form of a rotatable wheel 29 in a bearing block 30, on the inside of the support 26. Wheels 27 and 29 run along the surface 5 of track 1. However, wheel 27 is arranged to follow the profile in region 12 of block 7, and wheel 29 is arranged to follow the profile in region 16 of block 7. As will be appreciated, leading block 28 and wheel 27 are provided at the front of the carrier 24, and the inwardly spaced trailing block 30 and wheel 29 are provided at the rear of the carrier.

As the wheels move along track 1 and follow their respective profiles in regions 12 and 16, the carrier 24 is maintained in a horizontal orientation but is dipped into the solder for an amount sufficient to coat required parts of components and is then lifted clear again.

Movement of the carrier is effected by means of a chain conveyor mounted on frame 20, including chain links 31 which pass through a chain guide 32, around an idler sprocket (not shown) and around a drive sprocket driven by an electic motor (not shown). The speed of the drive can be adjusted. On the chain conveyor are provided arms 33 with depending fingers 34, one or more of which engages the support 26 of carrier 24, for example by being received in a slot in the left hand edge of the support. The depth of the finger 34 is such as to maintain engagement with the support 26 as the carrier 24 is lowered and raised. A number of carriers will normally be processed in series, each being moved by a respective one of the longitudinally spaced fingers.

The right hand side of the apparatus, using track 2, corresponds exactly with the exception that it may not be necessary to provide a second drive mechanism. It might be desirabble, in the absence of a second drive mechanism (which would normally be linked to or otherwise co-ordinated with the first), to provide a guide to assist in directing the carrier in a straight line down the track.

The particular arrangement described and illustrated has many advantages which will also apply to other systems employing at least some of the novel features and concepts disclosed. The apparatus has great flexibility and can be used to solder all types of semiconductor leads from the smallest SOIC's to long lead components and power transistors. The system, involving longitudinal movement and vertical dipping whilst retaining a horizontal orientation, is extremely flexible whilst giving good results. Because constant movement can be maintained, output can be increased to levels at least as good as those achieved with wave soldering and better than those achieved with static dipping. Dross formation can be reduced as compared to wave soldering systems.

## Claims

1. In combination, a horizontally oriented carrier (24) having tracks arranged to have removably mounted therein electronic integrated circuit packs with their leads pointing downwards, and apparatus for applying solder to the leads of the packs, the combination including a solder bath (22), a guide track (1,2) for guiding the carrier across the solder bath, means (31,32,33,34) for urging the carrier along the guide track, a first follower (27) for supporting a leading portion of the carrier on the guide track, and a second follower (29) longitudinally spaced from the first follower for supporting a trailing portion of the carrier on the guide track, characterised in that the guide track has a first profiled region (12,35) for guiding the first follower (27) down towards the surface (23) of the solder, and a second profiled region (16, 20) longitudinally spaced from the first region for simultaneously guiding the second follower (29) down towards the surface (23) of the solder, the first and second profiled regions (12,35;16,20) of the guide track being laterally offset from each other, and the first and second followers (27,29) for supporting the leading and trailing portions of the carrier being likewise laterally offset from each other so that when the carrier is urged along the guide track the first follower (27) bypasses the second profiled region (16,20) and the second follower (29) bypasses the first profiled region (12,35), wherein the profiles of the first and second profiled regions are the same and the longitudinal spacing of the profiled regions from each other is the same as the longitudinal spacing of the first and second followers from each other, so that when the carrier (24) is urged along the guide track it maintains its horizontal orientation at the same time as being moved vertically towards and away from the surface of the solder so as to dip the leads of the packs in the solder.

2. A carrier and apparatus as claimed in claim 1, wherein a guide track (1,2) is provided on each side of the solder bath (22).

3. A carrier and apparatus as claimed in claim 1 or 2, wherein each profiled region (12,35;16,20) consists of a downwardly inclined region (13,17), a horizontal region (14,18) and an upwardly inclined region (15,19).

4. A carrier and apparatus as claimed in claim 1, 2 or 3, wherein the means (31,32,33,34) for urging the carrier (24) along the guide track (1,2) comprises a chain conveyor (31,32,33) with a plurality of fingers (34) for engagement with the carrier.

5. A carrier and apparatus as claimed in any of claims 1 to 4, wherein each of the profiled regions (12,35;16,20) is replaceable.

6. A carrier and apparatus as claimed in any of claims 1 to 4, wherein the guide track (1,2) has a cut-out (3,4) with a block (7,8) located releasably therein, the block having the first and second profiled regions (12,35;16,20) of the guide track defined thereon.

**Patentansprüche**

1. Kombination eines horizontal orientierten Trägers (24) mit Bahnen, die angeordnet sind, um darin elektronische integrierte Schaltkreisbaueinheiten mit nach unten zeigenden Anschlüssen entfernbar anzubringen, mit einer Vorrichtung zum Aufbringen von Lötmittel auf die Anschlüsse der Baueinheiten, wobei die Kombination umfaßt: ein Lötbad (22), eine Führungsbahn (1, 2) zum Führen des Trägers über das Lötbad, Mittel (31, 32, 33, 34) zum Führen des Trägers entlang der Führungsbahn, einen ersten Folger (27) zum Halten eines führenden Trägerabschnitts auf der Führungsbahn und einen zweiten Folger (29) mit Längsabstand von dem ersten Folger zum Halten eines nachfolgenden Trägerabschnitts auf der Führungsbahn,

**dadurch gekennzeichnet,**

daß die Führungsbahn einen ersten profilierten Bereich (12, 35) zum Führen des ersten Folgers (27) nach unten zur Oberfläche (23) des Lötmittels hin aufweist und einen zweiten profilierten Bereich (16, 20) mit Längsabstand von dem ersten Bereich zum gleichzeitigen Führen des zweiten Folgers (29) nach unten zur Oberfläche (23) des Lötmittels hin aufweist, wobei die ersten und zweiten profilierten Bereiche (12, 35; 16, 20) der Führungsbahn seitlich voneinander versetzt sind und die ersten und zweiten Folger (27, 29) zum Halten der führenden und der nachfolgenden Abschnitte des Trägers ebenfalls seitlich voneinander versetzt sind, so daß, wenn der Träger entlang der Führungsbahn geführt wird, der erste Folger (27) an dem zweiten profilierten Bereich (16, 20) vorbeiläuft und der zweite Folger (29) an dem ersten profilierten Bereich (12, 35) vorbeiläuft, wobei die Profile der ersten und zweiten profilierten Bereiche gleichartig sind und der Längsabstand der profilierten Bereiche voneinander der gleiche ist wie der Längsabstand der ersten und zweiten Folger voneinander, so daß der Träger (24), wenn er entlang der Führungsbahn geführt wird, seine horizontale Orientierung beibehält, während er gleichzeitig vertikal zu der Lötmitteloberfläche hin und davon weg bewegt wird, so daß die Anschlüsse der Baueinheiten in das Lötmittel eintauchen.

2. Träger und Vorrichtung nach Anspruch 1, worin die Führungsbahn (1, 2) jederseits des Lötbads (22) vorgesehen ist.

3. Träger und Vorrichtung nach Anspruch 1 oder 2, worin jeder profilierte Bereich (12, 35; 16, 20) aus einem nach unten geneigten Bereich (13, 17), einem horizontalen Bereich (14, 18) und einem nach oben geneigten Bereich (15, 19) besteht.

4. Träger und Vorrichtung nach Anspruch 1, 2 oder 3, worin das Mittel (31, 32, 33, 34) zum Führen des Trägers (24) entlang der Führungsbahn (1, 2) einen Kettenförderer (31, 32, 33) mit einem Mehrzahl Fingern (34) zum Eingriff mit dem Träger umfaßt.

5. Träger und Vorrichtung nach einem der Ansprüche 1 bis 4, worin die profilierten Bereiche (12, 35; 16, 20) austauschbar sind.

6. Träger und Vorrichtung nach einem der Ansprüche 1 bis 4, worin die Führungsbahn (1, 2) einen Ausschnitt (3, 4) mit einem darin entfernbar angeordneten Block (7, 8) aufweist, wobei die ersten und zweiten profilierten Bereiche (12, 35; 16, 20) der Führungsbahn an dem Block vorgesehen sind.

**Revendications**

1. En combinaison, un porteur (24) orienté horizontalement, comportant des rails agencés de manière à recevoir de façon amovible des ensembles de circuits intégrés électroniques, dont les fils pointent vers le bas, et un appareil pour appliquer du métal d'apport aux fils des ensembles, la combinaison comprenant un bain (22) de métal d'apport, un rail (1, 2) de guidage pour guider le porteur à travers le bain de métal d'apport, des moyens (31, 32, 33, 34) pour entraîner le porteur le long du rail de guidage, un premier suiveur (27) destiné à supporter une partie avant du porteur sur le rail de guidage, et un deuxième suiveur (29), espacé longitudinalement par rapport au premier suiveur, destiné à supporter une partie arrière du porteur sur le rail de guidage, caractérisés en ce que le rail de guidage comporte une première zone profilée (12, 35) destinée à guider le premier suiveur (27) vers le bas, vers la surface (23) du métal d'apport, et une deuxième zone profilée (16, 20), espacée longitudinalement de la première zone, destinée à guider simultanément le deuxième suiveur (29) vers le bas, vers la surface (23) du métal d'apport, les première et deuxième zones profilées (12, 35; 16, 20) du rail de guidage étant décalées latéralement l'une par rapport à l'autre, et les premier et deuxième suiveurs (27, 29) supportant les parties avant et arrière du porteur étant décalés latéralement l'un par rapport à l'autre de la même façon, de manière telle que, lorsque le porteur est entraîné le long du rail de guidage, le premier suiveur (27) contourne la deuxième zone profilée (16, 20) et que le deuxième suiveur (29) contourne la première zone profilée (12, 35), et où les profils des première et deuxième zones profilées sont identiques, et où l'espacement longitudinal entre les zones profilées est le même que l'espacement longitudinal entre les premier et deuxième suiveurs, de telle sorte que, lorsque le porteur (24) est entraîné le long du rail de guidage, il maintienne son orientation horizontale au moment où il est déplacé verticalement en direction de et au loin de la surface de métal d'apport, de manière à tremper les fils des ensembles dans le métal d'apport.

2. Porteur et appareil selon la revendication 1, dans lesquels un rail (1, 2) de guidage est prévu de chaque côté du bain (22) de métal d'apport.

3. Porteur et appareil selon l'une des revendications 1 ou 2, dans lesquels chaque zone profilée (12, 35; 16, 20) se compose d'une zone (13, 17) inclinée vers le bas, d'une zone horizontale (14, 18) et d'une zone (15, 19) inclinée vers le haut.

4. Porteur et appareil selon l'une des revendications 1, 2 ou 3, dans lesquels les moyens (31, 32, 33, 34) d'entraînement du porteur (24) le long du rail (1, 2) de guidage comportent un convoyeur à chaîne (31, 32, 33) pourvu d'une série de doigts (34) destinés à s'engager dans le porteur.

5. Porteur et appareil selon l'une quelconque des revendications 1 à 4, dans lesquels chacune des zones profilées (12, 35; 16, 20) est remplaçable.

6. Porteur et appareil selon l'une quelconque des revendications 1 à 4, dans lesquels le rail (1, 2) de guidage comprend une découpe (3, 4), un bloc (7, 8) étant logé de façon amovible dans celle-ci, le bloc comprenant des première et deuxième zones profilées (12, 35; 16, 20) du rail de guidage, qui sont définies dans ce bloc.

FIG 1.

UP/DOWN GUIDE BLOCKS

CONNECTING RAILS

EP 0 252 771 B1

FINGER

CHAIN

BEARING BLOCK

Fig 2

31

33

3,4

28

26

32

24

20

21

CHAIN-GUIDE

30

29

PALLET

5

25

23

1

27

7

16

SOLDER LEVEL

12

UP/DOWN GUIDE BLOCK

22

EP 0 252 771 B1

8